# EUROPEAN PATENT APPLICATION

(11) **EP 4 102 538 A1**
(43) Date of publication of application: **14.12.2022**
(21) Application number: 21841537.0
(22) Date of filing: 06.07.2021
(51) Int. Cl.: H01J 37/32

(54) **OIL SPLASH PREVENTION SYSTEM AND METHOD FOR ROTARY PLASMA HEAD**

(30) Priority: 14.07.2020 KR 20200086839
(71) Applicant: Lee, Chang Hoon, Seoul 03477 (KR)
(72) Inventor: Lee, Chang Hoon, Seoul 03477 (KR)
(74) Representative: Studio Torta S.p.A.
(86) International application number: PCT/KR2021/008598
(87) International publication number: WO 2022/014939

(57) **Abstract**

A system and a method for preventing oil splash in a rotary-type plasma head is provided, including a nozzle unit through which plasma is discharged, a rotating body unit, in which the nozzle unit is attached to and detached from one side of the rotating body unit, the other side of the rotating body unit is connected to a housing unit, and the rotating body unit is configured to drive the nozzle unit to rotate, and an oil cover unit connected to one side of the nozzle unit and configured to surround the rotating body unit from outside, to prevent oil vapor or oil micro-droplets discharged through joints of components of the rotating body unit from leaking outside.

## Description

### TECHNICAL FIELD

The present invention relates to a system and a method for preventing oil splash in a rotary-type plasma head, and more particularly, to a system and a method for preventing oil splash in a rotary-type plasma head, which prevents secondary contamination of a plasma device or a workpiece from occurring due to oil leakage from the rotating head of a plasma device.

### BACKGROUND

The "plasma" refers to a collection of particles comprised of ion nuclei and free electrons that are generated when the temperature is increased by continuous application of heat to a gaseous substance. This state of matter is called the "plasma state", and is called the fourth state of matter, after the states of matter of solid, liquid and gas. The plasma state is electrically neutral, and when used as a coating on a surface of a material, it can prevent abrasion or corrosion, and thus provide the effect of enhancing the state of the material.

In general, an atmospheric pressure plasma generator includes a tube configured to generate plasma when compressed air or plasma generating gas is collided with high-frequency, high-voltage electric charges. The atmospheric pressure plasma device may be applied to various materials and substrates with low-temperature process, and since it does not require a vacuum container or a vacuum evacuation device, fast and economic treatment is provided. In addition, when used, a deposition method using the atmospheric pressure plasma provides good adhesion and low deposition temperature, and thus, it is used in relatively various industries by utilizing the advantages such as reduction in deformation or denaturation that accompanies high temperature heating in the related surface treatment process, semiconductor process, and display process.

In general, the atmospheric pressure plasma device may use a fixed plasma head to perform surface treatment on a specific area of the workpiece, or a rotary-type plasma header to perform surface treatment on a relatively large surface area by uniformly spraying a plasma beam of constant intensity thereon. In the rotary-type plasma generator, by the characteristic in which the nozzle for radiating plasma is rotated, a bearing may be used for smooth operation of a mechanical configuration that rotates the nozzle. In such a rotary-type plasma head, the bearing oil may leak outside through the joint of a body which is rotated under high temperature and high speed conditions. The oil leaking outside while the plasma nozzle is rotating is problematic, since it can contaminate other parts of the plasma generator or cause secondary contamination of the workpiece.

### SUMMARY

In order to address the problems occurring in the related art described above, the present disclosure provides a system and a method for preventing oil splash in a rotary-type plasma head, which prevents secondary contamination from occurring due to oil leakage of the rotating head of a plasma generator.

According to an embodiment of the present disclosure, a system and a method for preventing oil splash in a rotary-type plasma head are provided, which may include: a nozzle unit through which plasma is discharged; a rotating body unit, in which the nozzle unit may be attached to and detached from one side of the rotating body unit, the other side of the rotating body unit may be connected to a housing unit, and the rotating body unit may be configured to drive the nozzle unit to rotate; and an oil cover unit connected to one side of the nozzle unit and configured to surround the rotating body unit from outside, to prevent oil vapor or oil micro-droplets discharged through joints of components of the rotating body unit from leaking outside.

According to an embodiment, the nozzle unit may include a nozzle, and a nozzle body unit including a nozzle detaching unit formed at one side, in which the nozzle detaching unit may be configured such that the nozzle is attachable and detachable therefrom, and the other side of the nozzle body unit may be coupled to one side of the rotating body unit.

According to an embodiment, the rotating body unit may include a cylindrical rotating body formed at one side, and a rotating support formed at the other side and connected to one side of the housing unit, and the rotation support may include an oil hose unit and a bearing unit formed inside.

According to an embodiment, the oil cover unit may include a suction fan and an oil cover configured to accommodate the suction fan, the suction fan may be fixed to one side of the rotating body unit to move air flow inside the oil cover unit toward the housing unit through the oil hose unit formed inside the rotating body unit according to a rotation of the rotating body unit, thus sucking the oil vapor or oil micro-droplets, and the oil cover may prevent the oil from splashing out of the nozzle unit and the rotating body unit.

According to an embodiment, a housing cap, a front partition wall, a rear partition wall, a housing bottom part, and a suction tube connection pipe formed on a side surface of the front partition wall, may be included, and the suction tube connection pipe may discharge the oil vapor or oil micro-droplets outside through a suction tube connected to one side.

According to various embodiments of the present disclosure, it is possible to prevent secondary contamination of the plasma device or the workpiece which may be caused by oil leakage from the rotating head of the plasma device.

According to various embodiments of the present disclosure, it is possible to effectively prevent the leakage of oil vapor and oil micro-droplets that may be generated in the rotating head of the plasma device.

According to various embodiments of the present disclosure, it is possible to effectively discharge, to the outside, oil vapor and oil micro-droplets that may be generated in the rotating head of the plasma device.

According to various embodiments of the present disclosure, it is possible to effectively prevent secondary contamination that may occur due to the plasma generator in a process or other manufacturing facility using the plasma generator.

### BRIEF DESCRIPTION OF THE DRAWINGS

Embodiments of the present disclosure will be described with reference to the accompanying drawings described below, where similar reference numerals indicate similar elements, although the embodiments are not limited thereto.
FIG. 1 is a view illustrating a configuration of a system for preventing oil splash in a rotary-type plasma head according to an embodiment of the present disclosure.
FIG. 2 is a perspective view illustrating the inside of the rotary-type plasma head according to an embodiment of the present disclosure.
FIG. 3 is a side view illustrating the inside of the rotary-type plasma head according to an embodiment of the present disclosure.
FIG. 4 is a view illustrating a suction fan according to an embodiment of the present disclosure.
FIG. 5 is a flowchart illustrating a method for preventing oil splash in a rotary-type plasma head according to an embodiment of the present disclosure.

### DETAILED DESCRIPTION

In the accompanying drawings, the same or corresponding elements are assigned the same reference numerals. In addition, in the following description of the embodiments, duplicate descriptions of the same or corresponding elements may be omitted. However, even if descriptions of elements are omitted, it is not intended that such elements are not included in any embodiment.

Advantages and features of the disclosed examples and methods of accomplishing the same will be apparent by referring to embodiments described below in connection with the accompanying drawings. However, the present disclosure is not limited to the embodiments disclosed below, and may be implemented in various different forms, and the embodiments are merely provided to make the present disclosure complete, and to fully disclose the scope of the invention to those skilled in the art to which the present disclosure pertains.

The terms used in the present disclosure will be briefly described prior to describing the disclosed embodiments in detail.

The terms used herein have been selected as general terms which are widely used at present in consideration of the functions of the present disclosure, and this may be altered according to the intent of an operator skilled in the art, conventional practice, or introduction of new technology. In addition, in specific cases, certain terms may be arbitrarily selected by the applicant, and the meaning of the terms will be described in detail in a corresponding description of the embodiment(s). Therefore, the terms used in the present disclosure should be defined based on the meaning of the terms and the overall content of the present disclosure rather than a simple name of each of the terms.

As used herein, the singular forms "a," "an," and "the" are intended to include the plural forms as well, unless the context clearly indicates the singular forms. Further, the plural forms are intended to include the singular forms as well, unless the context clearly indicates the plural forms.

Further, throughout the description, when a portion is stated as "comprising (including)" an element, it intends to mean that the portion may additionally comprise (or include or have) another element, rather than excluding the same, unless specified to the contrary.

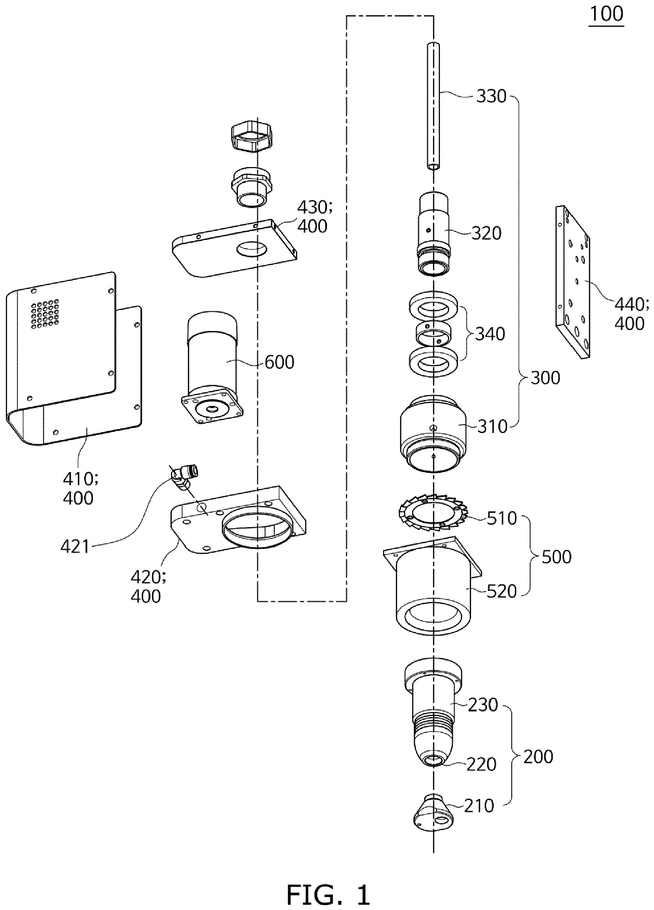

FIG. 1 is a view illustrating a configuration of a system for preventing oil splash in a rotary-type plasma head according to an embodiment of the present disclosure.

As illustrated, a system 100 for preventing oil splash in a rotary-type plasma head may include a nozzle unit 200 from which plasma is discharged, a rotating body unit 300 which is, at one side, attached to and detached from the nozzle unit and, at the other side, connected to a housing unit, and an oil cover unit 500 connected to the rotating body unit from the outside to prevent oil from leaking outside the nozzle unit.

For example, the system 100 may be an atmospheric pressure plasma generator that generates plasma by discharging at a pressure of about 760 Torr which is atmospheric pressure. The system 100 may use the generated plasma for surface treatment of a workpiece made of an organic polymer material, and in this case, it is possible to improve hydrophobicity, hydrophilicity, dyeability, adhesiveness, and the like of the polymer material. In another example, the system 100 may be used for surface treatment of a workpiece made of a metal material, and in this case, it is possible to improve the wear resistance and corrosion resistance of the surface by coating the surface of the metal with a carbide film such as TiN/C, CrN/C, AIN, and the like.

When the system 100 is an atmospheric pressure plasma generator, the system 100 may include a generator, a high voltage transformer, electrodes (not illustrated) for generating plasma discharge, and the like, so as to be driven in a normal room temperature and normal pressure environment. The high frequency high voltage generated by the high voltage transformer is applied to the electrodes installed inside the system 100, and a high frequency discharge in the form of an electric arc is generated between the electrodes by the applied voltage. As described above, in a state that the generated electric arc is inside the system 100, the working gas is contacted with the electric arc and converted into the plasma state. The plasma beam generated in the system 100 is discharged through the nozzle unit 200.

The nozzle unit 200 includes a nozzle 210, a nozzle detaching unit 220 formed at one side to attach and detach the nozzle 210, and a nozzle body unit 230 formed at the other side and coupled to one side of the rotating body unit 300.

The nozzle body unit 230 may form a space in which electrons generated from the electrode is discharged through the working gas. Meanwhile, the nozzle 210 may be designed to have various shapes such that the area in which the plasma beam spreads, its intensity, and the like can be adjusted. According to positions and sizes of nozzle holes formed in the nozzle 210, the direction of injection and diameter of the plasma beam discharged through this may be determined, and the radius and length of injection of the plasma beam may be determined according to shapes of the nozzle holes. The main material of the nozzle 210 may be a metal material such as aluminum, brass, stainless steel, or the like.

The nozzle detaching unit 220 may be manufactured in compliance with standard specifications for compatibility with nozzles of various shapes. Various depths and sizes of nozzle holes may be formed in the nozzle 210 as need arises according to the plasma surface treatment operation. In addition, the operator is able to easily replace only the nozzle 210 from the nozzle detaching unit 220 in accordance with the type of operation and perform the operation with precision, and also quickly cope with diverse variables.

According to an embodiment, the rotating body unit 300 includes a cylindrical rotating body 310 formed at one side, and a rotating support 320 connected to one side of a housing unit 400 formed at the other side. In addition, the rotating body unit 300 includes an oil hose unit 330 and a bearing unit 340 formed inside the rotation support 320.

The nozzle unit 200 may be attached to and detached from the one side of the rotating body unit 300, and the other side of the rotating body unit 300 may be connected to the housing unit 400. As described above, the rotating body unit 300 is configured such that it 300 is connected to the nozzle unit 200 and the housing unit 400 on both sides so as to serve as a frame containing therein the rotation support 320, the oil hose unit 330, and the bearing unit 340, while also playing a role of transmitting the rotational force transmitted from a rotation power unit 600 to the nozzle unit 200 to rotate the nozzle unit 200. The rotating body unit 300 may be manufactured by precision processing a rigid material.

According to an embodiment, in the rotary-type plasma generator, by the structural characteristic in which the nozzle for radiating the plasma is rotated, a bearing may be used for smooth operation of a mechanical configuration that rotates the nozzle. Specifically, the bearing unit 340 may be configured inside the rotating body unit 300 to allow smooth rotation of the rotating body unit 300, and may include bearing oil therein.

When the rotating body unit 300 of the rotary-type plasma head is rotated under high temperature and high speed conditions, the bearing oil of the bearing unit 340 may be vaporized or micro-dropletized and leak outside through the joints of the components of the rotating body unit 300. There is a problem that the oil vapor and oil micro-droplets leaking outside during the rotation of the plasma head contaminate the other parts of the plasma generator or cause secondary contamination of the workpiece.

In order to address the problems mentioned above, the oil cover unit 500 according to the present disclosure includes a suction fan 510 formed inside and an oil cover 520 formed outside. The suction fan 510 may be fixed to one side of the rotating body unit 300 with a screw. The suction fan 510 may be configured to move a flow of air inside the oil cover unit 500 toward the housing unit 400 through the oil hose unit 330 formed inside the rotating body unit 300 so as to discharge the oil vapor and oil micro-droplets outside. In addition, the oil cover 520 is configured to prevent the oil vapor and oil micro-droplets from splashing out of the nozzle unit 200 and the rotating body unit 300.

According to an embodiment, the housing unit 400 includes a housing cap 410, a front partition wall 420, a rear partition wall 430, and a housing bottom part 440. The housing unit 400 further includes a suction tube connection pipe 421 connected to a side of the front partition wall 420. The suction tube connection pipe 421 is configured to be attachable to and detachable from a suction tube (not illustrated) connected to a suction device such as a vacuum suction device. In this configuration, the suction device (not illustrated) discharges the oil vapor and oil micro-droplets moved through the suction tube connection pipe 421 connected to the suction tube to an external pipe or container.

The system for preventing oil splash in the rotary-type plasma head having the configuration described above may prevent the oil vapor and oil micro-droplets from leaking out through the following operations. Specifically, during an operation of the plasma head that is rotated with high speed, if the bearing oil used in the bearing unit 340 is vaporized and micro-dropletized, the oil vapor and oil micro-droplets are prevented from leaking out, by the oil cover unit 500 attached to the one side of the nozzle unit 200 and the outer side of the rotating body unit 300. That is, the oil cover 520 formed outside the oil cover unit 500 can prevent the oil vapor and oil micro-droplets discharged out of the nozzle unit 200 and the rotating body unit 300 from splashing. Meanwhile, the suction fan 510 formed inside the oil cover unit 500 may be rotated integrally with the rotating body unit 300, moving the air flow inside the oil cover unit 500 toward the housing unit 400 through the oil hose unit 330 formed inside the rotating body unit 300, and thereby sucking and moving oil vapor and oil micro-droplets contained in the oil cover unit 500 to the housing unit 400. In addition, the oil that is moved and sucked as described above may be discharged to an external pipe or container through a suction tube (not illustrated) connected to the suction tube connection pipe 421 installed on the front partition wall 420 of the housing unit 400.

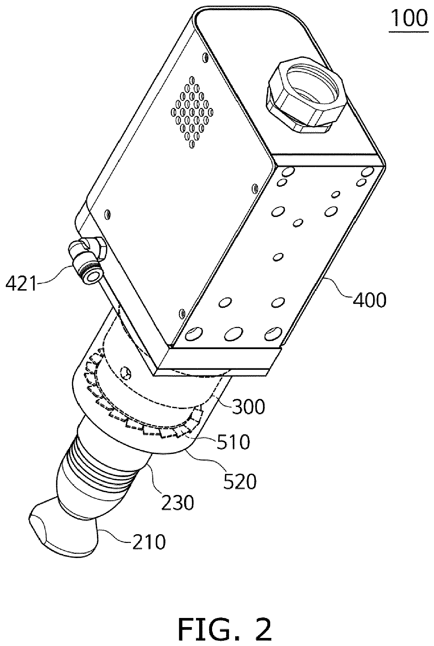

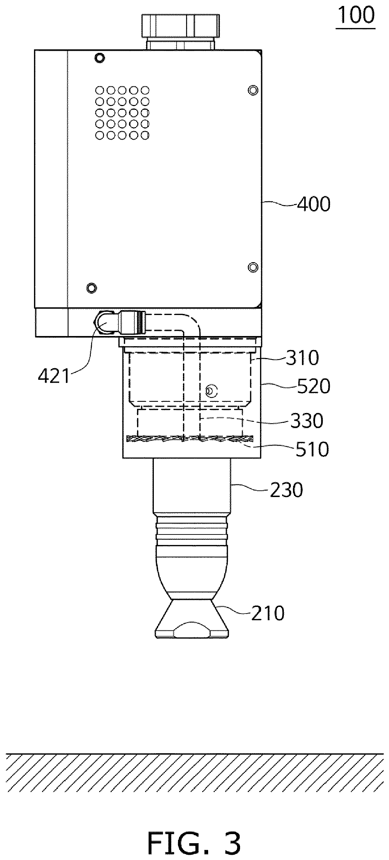

FIG. 2 is a perspective view illustrating the inside of the oil cover unit of the rotary-type plasma head according to an embodiment of the present disclosure, and FIG. 3 is a side view illustrating the inside of the oil cover unit of the rotary-type plasma head according to an embodiment of the present disclosure.

Among the elements of the system 100 for preventing oil splash in the rotary-type plasma head illustrated in FIGS. 2 and 3, the elements denoted by the same reference numerals as those of the system 100 shown in FIG. 1 may have the same or similar functions and configurations. Accordingly, hereinafter, detailed descriptions of the functions and configurations of the elements denoted by the same reference numerals as those of the system 100 illustrated in FIG. 1 may be omitted.

As illustrated, the system 100 for preventing oil splash in the rotary-type plasma head may include a nozzle unit 200, a rotating body unit 300, a housing unit 400, and an oil cover unit 500.

As described with reference to FIG. 1, the oil cover 520 is formed outside the oil cover unit 500 to prevent oil (e.g., oil vapor and oil micro-droplets) from splashing out of the nozzle unit 200 and the rotating body unit 300.

In addition, the suction fan 510 formed inside the oil cover unit 500 is rotated while being fixed to the rotating body unit 300, thus moving the internal air flow to the housing unit 400 through the oil hose unit 330 formed inside the rotating body unit 300. According to this air flow, the oil inside the oil cover unit 500 is discharged to an external pipe or container through a suction tube (not illustrated) connected to the suction tube connection pipe 421 installed on the front partition wall 420 of the housing unit 400.

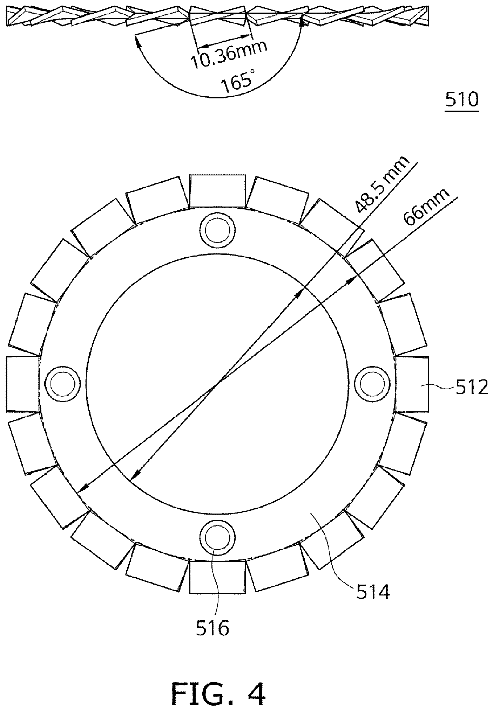

FIG. 4 shows a side view and a plan view of the suction fan 510 according to an embodiment of the present disclosure.

Any one of the suction fans 510 illustrated in FIGS. 1 to 3 described above may include the configuration of the suction fan 510 of FIG. 4. As illustrated, the suction fan 510 may include a blade unit 512, a frame unit 514, and a fixing unit 516.

The blade unit 512 of the suction fan 510 may include a plurality of blade units formed along an outer periphery of the frame unit 514 at an angle of about 15 to 17 degrees (preferably about 15 degrees) with respect to the plane of the suction fan 510 (or the frame unit 514). The width of each blade of the blade units 512 may be about 10 to 12 mm (preferably about 10.36 mm). In addition, a gap of about 1 to 2 mm (preferably about 1 mm) may be formed between the blades of the blade units 512. The angle and length of the blades of the blade units 512 described above and interval therebetween are not limited to the above, and may be changed to various numerical values or shapes as long as the function of preventing oil splash in the rotary-type plasma head can be performed.

In addition, four fixing units 516 may be formed in the frame unit 514 of the suction fan 510. The suction fan 510 may be attached to and detached from the rotating body unit 300 through the fixing units 516, and the method of fixing the suction fan 510 and the body unit 300 may include screw thread coupling, tightening with an accessory screw thread, force fitting, and the like, but is not limited thereto. Preferably, the method of fixing the suction fan 510 and the body unit 300 may include coupling with a screw thread including an O-ring.

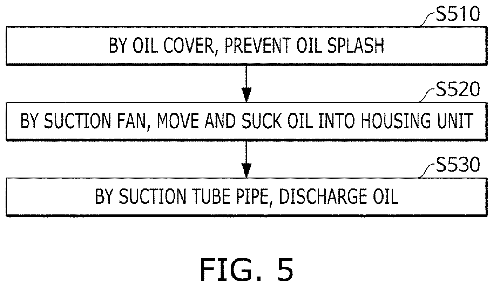

FIG. 5 is a flowchart illustrating a method for preventing oil splash in a rotary-type plasma head according to an embodiment of the present disclosure.

The method for preventing oil splash in the rotary-type plasma head according to the embodiment prevents oil vapor and oil micro-droplets from leaking from the oil cover unit 500 which is attached to the one side of the nozzle unit 200 and to the outside of the rotating body unit 300, when the oil vapor and oil micro-droplets are generated during the operation of a high-speed rotary-type plasma device.

The method is initiated with the step S510 of preventing, with the oil cover, the oil from splashing (that is, oil splash). In an embodiment, referring to FIGS. 1 to 4, during the operation of the plasma head that is rotated with high speed, if the bearing oil used in the bearing unit 340 is vaporized and micro-dropletized, the oil vapor and oil micro-droplets are prevented from leaking out, by the oil cover unit 500 attached to the one side of the nozzle unit 200 and the outer side of the rotating body unit 300. That is, the oil cover 520 formed outside the oil cover unit 500 can prevent the oil vapor and oil micro-droplets discharged outside the nozzle unit 200 and/or the rotating body unit 300 from splashing.

In addition, the oil is moved and sucked into the housing unit by the suction fan (S520). In an embodiment, referring to FIGS. 1 to 4, the suction fan 510 formed inside the oil cover unit 500 may be rotated integrally with the rotating body unit 300, moving the air flow inside the oil cover unit 500 toward the housing unit 400 through the oil hose unit 330 formed inside the rotating body unit 300, and thereby sucking and moving oil vapor and oil micro-droplets contained i

Finally, the oil is discharged outside through the suction tube pipe (S530). In an embodiment, referring to FIGS. 1 to 4, the oil can be discharged to an external pipe or container through a suction tube (not illustrated) connected to the suction tube connection pipe 421 installed on the front partition wall 420 of the housing unit 400.

Although the present disclosure has been described in connection with certain embodiments herein, it should be understood that various modifications and changes can be made without departing from the scope of the present disclosure, which can be understood by those skilled in the art to which the present disclosure pertains. In addition, such modifications and changes should be considered within the scope of the claims appended herein.

## Claims

1. A system for preventing oil splash in a rotary-type plasma head, comprising:
a nozzle unit through which plasma is discharged;
a rotating body unit, wherein the nozzle unit is attached to and detached from one side of the rotating body unit, the other side of the rotating body unit is connected to a housing unit, and the rotating body unit is configured to drive the nozzle unit to rotate; and
an oil cover unit connected to one side of the nozzle unit and configured to surround the rotating body unit from outside, to prevent oil vapor or oil micro-droplets discharged through joints of components of the rotating body unit from leaking outside.

2. The system according to claim 1, wherein the nozzle unit includes:
a nozzle; and
a nozzle body unit including a nozzle detaching unit formed at one side, wherein the nozzle detaching unit is configured such that the nozzle is attachable and detachable therefrom, and the other side of the nozzle body unit is coupled to one side of the rotating body unit.

3. The system according to claim 1, wherein the rotating body unit includes a cylindrical rotating body formed at one side, and a rotating support formed at the other side and connected to one side of the housing unit, and
the rotation support includes an oil hose unit and a bearing unit formed inside.

4. The system according to claim 1, wherein the oil cover unit includes a suction fan, and an oil cover configured to accommodate the suction fan,
the suction fan is fixed to one side of the rotating body unit to move air flow inside the oil cover unit toward the housing unit through the oil hose unit formed inside the rotating body unit according to a rotation of the rotating body unit, thus sucking the oil vapor or oil micro-droplets, and
the oil cover prevents the oil from splashing out of the nozzle unit and the rotating body unit.

5. The system according to claim 1, wherein the housing unit includes a housing cap, a front partition wall, a rear partition wall, a housing bottom part, and a suction tube connection pipe formed on a side surface of the front partition wall, and
the suction tube connection pipe is configured to discharge the oil vapor or oil micro-droplets outside through a suction tube connected to one side.
